Europäisches Patentamt

European Patent Office

Office européen des brevets

(19)

(11) Veröffentlichungsnummer : **0 314 681 B1**

(12) # EUROPÄISCHE PATENTSCHRIFT

(45) Veröffentlichungstag der Patentschrift :
11.09.91 Patentblatt 91/37

(51) Int. Cl.⁵ : **H02M 7/5387, H03K 17/687**

(21) Anmeldenummer : 87903860.2

(22) Anmeldetag : 20.06.87

(86) Internationale Anmeldenummer :
PCT/DE87/00282

(87) Internationale Veröffentlichungsnummer :
WO 88/00770 28.01.88 Gazette 88/03

(54) **ENDSTUFE IN BRÜCKENSCHALTUNG.**

(30) Priorität : 24.07.86 DE 3625091

(43) Veröffentlichungstag der Anmeldung :
10.05.89 Patentblatt 89/19

(45) Bekanntmachung des Hinweises auf die
Patenterteilung :
11.09.91 Patentblatt 91/37

(84) Benannte Vertragsstaaten :
DE FR GB IT SE

(56) Entgegenhaltungen :
EP-A- 0 038 624
FR-A- 2 565 292
US-A- 4 520 438

(73) Patentinhaber : ROBERT BOSCH GMBH
Postfach 50
W-7000 Stuttgart 1 (DE)

(72) Erfinder : PETER, Cornelius
Burg-Windeck-Str. 35
W-7583 Ottersweier (DE)
Erfinder : RIEHEMANN, Thomas
Haabergstr. 119a
W-7582 Bühlertal (DE)

EP 0 314 681 B1

## Beschreibung

Stand der Technik

Die Erfindung betrifft eine Einrichtung zur Steuerung einer Brückenschaltung aus vier Stromsteuerorganen, in deren einer Diagonale der Verbraucher liegt, nach dem Oberbegriff des Anspruchs 1. Eine solche Einrichtung ist aus EP-A-38624 bekannt. Aus DE-A-3420611 ist weiter eine Einrichtung bekannt, bei der eine Diagonale der Brückenschaltung nur den elektromagnetischen Verbraucher umfaßt. Dieser Brückenschaltung ist eine Serienschaltung aus einem weiteren Stromsteuerorgan und einem Meßwiderstand nachgeschaltet. Hierdurch soll ereicht werden, daß die Steuerung des Stroms durch den Verbraucher und die Steuerung der Polarität dieses Stroms schaltungstechnisch getrennt sind. Die Stromsteuerorgane in der bekannten Brückenschaltung sind bipolare Transistoren, und zwar je zwei vom PNP- und je zwei vom NPN-Typ. Derartige bipolare Transistoren benötigen zum Ein- und Ausschalten eine Verlustenergie, die während des Schaltvorgangs in den Transistoren umgesetzt wird.

Weiterhin ist aus der US-A-4520438 eine Brückenschaltung aus vier bipolaren Transistoren bekannt, in deren diagonale ein Motor angeschlossen ist. Jedem dieser Transistoren ist über dessen Basis-Emitter-Strecke ein Basisstrom-Shunttransistor in Serie mit einer Induktivität und einer Diode zugeschaltet. Mit der aus US-A-4520438 bekannten Schaltung soll erreicht werden, daß der Basistreiberstrom sich bei Änderung der Betriebsbedingungen möglichst wenig ändert.

Die relativ hohe Verlustenergie der geschalteten Transistoren der Brückenschaltung stellt, wenn es wie beispielsweise bei elektromagnetischen Verbrauchern in Kraftfahrzeugen, aber auch im Zusammenhang mit Computern auf niedrige Verlustleistung ankommt, ein Problem dar. Weiterhin ist in den genannten Schriften nichts über eine Sicherung der Endstufe gegen Kurzschluß ausgesagt.

Vorteile der Erfindung

Die erfindungsgemäße Einrichtung zur Steuerung und Regelung des Stroms durch einen elektromagnetischen Verbraucher mit einer Brückenschaltung, in deren einer Diagonale der Verbraucher liegt, aus vier Stromsteuerorganen vom Logic-Level Leistungs-MOSFET-Typ, an welche je paarweise eine Spannungsregelschaltung zur Gatespannungsversorgung und eine Stromsteuerschaltung zur Gatespannungssteuerung angeschlossen ist, und mit zumindest einem an einem Anschlußpunkt der zweiten Diagonale angeschlossenen Meßwiderstand hat gegenüber dem Stand der Technik den Vorteil, daß auf Grund des äußerst niedrigen Widerstands derartiger Leistungs-MOSFETS zum Betrieb der Schaltung nur eine dementsprechend äußerst niedrige Verlustleistung erforderlich ist. Auch der Meßwiderstand kann einen sehr geringen Widerstandswert aufweisen. Die Gatespannungsversorgung über Spannungsregler gestattet einen geringen Spannungsabfall von typisch 1,2 Volt sowie einen Eingangsschutz vor negativen Spannungen. In Folge der Gatespannungssteuerung über Stromquellen treten keine Probleme durch Störungen auf der Versorgungsspannung auf, weiterhin ist nur eine niedrige Verlustleistung der Ansteuerschaltung erforderlich. Ein weiterer Vorteil ist darin zu sehen, daß die erfindungsgemäße Einrichtung in einem breiten Spannungsbereich arbeiten kann, der höchstens von der Spannungsfestigkeit der Stromsteuerorgane der Endstufe begrenzt wird.

Bei der Erfindung ist die Spannungsregelschaltung aus diskreten Bauelementen aufgebaut und weist eine Diode auf, deren Kathode an den Kollektor eines NPN-Transistors und an einen Widerstand angeschlossen ist, dessen anderer Anschluß an die Basis des Transistors, mit der die Kathode einer Zenerdiode verbunden ist, angeschlossen ist. Ein derartiger Aufbau läßt sich besonders einfach hybridisieren oder integrieren, da insbesondere die Kapazität des Gatespannungskondensators für die Logic-Level Leistungs-MOSFET-Stromsteuerorgane um einen Faktor 1000, verglichen mit der bei einem integrierten Schaltkreis benötigten Kapazität, verringert werden kann.

Diese Kapazität ist das wesentliche Element einer Spannungserhöhungsschaltung (Bootstrap) zur Gate-Ansteuerung der Stromsteuerorgane. Vorteilhafterweise erfolgt die Aufladung dieser Kapazität nur während der Ausschaltzeit der Stromsteuerorgane.

Ein besonders wichtiger Vorteil ergibt sich gemäß einer weitern vorteilhaften Ausgestaltung der Erfindung dann, wenn eine Stromüberwachungsschaltung vorgesehen ist, die eine Vergleicherschaltung aufweist, die bei einem Maximalstrom durchschaltet und eine Kapazität entlädt und die Stromsteuerorgane über die andere Vergleicherschaltung sperrt. Durch geeignete Bemessung der Auf- bzw. Entladezeitkonstanten der Kapazität läßt sich nämlich erreichen, daß sich im Fall eines Kurzschlußes des elektromagnetischen Verbrauchers ein Einschalttastverhältnis von typisch 1% ergibt.

Wird nach einer weiteren vorteilhaften Ausgestaltung der Erfindung eine Korrekturschaltung zur Erzeugung einer Offsetspannung vorgesehen, die an den Eingang der Vergleicherschaltung der Stromüberwachungsschaltung angelegt ist, so kann eine sehr schnelle Strommessung ohne Gleichtaktprobleme erfolgen und auch eine Erfassung der Freilaufströme des elektromagnetischen Verbrauchers ohne das Auftreten von Umschaltspitzen.

Ein weiterer wesentlicher Vorteil der Erfindung resultiert aus einer an einen Meßwiderstand angeschlossenen Diagnoseschaltung mit einem Differenzverstärker zur Erfassung des Stroms durch den Verbraucher als Spannung gegen Masse. Hierdurch läßt sich eine einfache Diagnose der aktuellen Betriebsparameter des elektromagnetischen Verbrauchers für Steuerungs-/Regelungszwecke erreichen ; insbesondere in Verbindung mit einer weiteren vorteilhaften Ausgestaltung der Erfindung, bei der eine an einen Meßwiderstand angeschlossene Diagnoseschaltung mit einem Differenzverstärker zur Erfassung des Stroms durch den Verbraucher als invertierte Spannung gegen die Versorgungsspannung vorgesehen ist. Dies ermöglicht eine vollständige Diagnose der Endstufe, bei welcher, wenn der Verbraucher ein Motor ist, ein Motornebenschluß, ein Nebenschluß nach Masse sowie ein Nebenschluß zur Versorgungsspannung sicher erkannt werden können.

Auch die Freilaufströme des elektromagnetischen Verbrauchers lassen sich bei der Diagnose erfassen, wenn eine weitere an den Meßwiderstand angeschlossene Diagnoseschaltung mit einem Differenzverstärker zur Erfassung dieser Freilaufströme vorgesehen wird.

Es ist auch möglich, die Freilaufphasen (negative Spannungsabfälle) einwandfrei auf Masse zu beziehen, wenn zwischen den Meßwirderstand und die eine und/oder die andere Diagnoseschaltung die Korrekturschaltung und eine dieser nachgeschaltete Stromspiegelschaltung geschaltet ist. Die Korrekturschaltung sorgt hierbei für eine positive Vorspannung für die Stromspiegelschaltung, die nur positive Spannungsabfälle am Meßwiderstand verarbeiten kann. Ein besonderer Vorteil liegt darin, daß sonst vorhandene Umschaltspitzen beim Übergang von negativem auf positiven Spannungsabfall verschwinden.

Bei einer weiteren vorteilhaften Ausgestaltung der Erfindung ist in der Stromquellenschaltung ein Schaltanschluß vorgesehen, in dessen unterbrochenem Zustand der elektromagnetische Verbraucher überbrückt ist, wodurch sich mit Hilfe eines externen (vorzugsweise elektronischen) Schalters eine Abbremsung des elektromagnetischen Verbrauchers auf Grund des Induktionsgesetzes ergibt.

Besonders für einen Einsatz der erfindungsgemäßen Einrichtung in Mikrocomputersystemen ist eine weitere Ausführungsform der Erfindung von Vorteil, bei welcher den nicht-invertierenden Eingängen der Differenzverstärker der Diagnoseschaltung eine positive Offsetspannung in Höhe der zu erwartenden Null-Offsetspannung aufgeschaltet ist. An den Ausgängen der Differenzverstärker liegt auch dann, wenn kein Strom in der Brücke fließt, unabhängig von der Polarität der Null-Offsetspannung eine positive Spannung an, die von einem Mikrocomputer beispielsweise über einen Analog/Digitalwandler eingelesen und bei Berechnungen, beispielsweise zur

Stromregelung, rechnerisch subtrahiert und so berücksichtigt werden kann.

Eine weitere Erhöhung der Betriebssicherheit der erfindungsgemäßen Einrichtung läßt sich durch Verwendung von Stromsteuerorganen mit einer integrierten Temperatursicherung erreichen. In diesem Fall ist die Schaltung auch gegen schleichende Kurzschlüsse, also Ströme kurz unterhalb der Abschaltschwelle, geschützt.

Von besonderer Bedeutung ist die Tatsache, daß die erfindungsgemäße Einrichtung auf Grund ihres geringen Leistungsbedarfs verhähtnismäßig einfach integriert oder hybridisiert ausgeführt werden kann, da ausschließlich Kleinleistungsbauelemente in der Ansteuerschaltung Verwendung finden, deren gesamter Leistungsbedarf weit unterhalb von 300 mW liegt.

Schließlich soll noch auf einen weiteren wichtigen Vorteil der erfindungsgemäßen Einrichtung aufmerksam gemacht werden, welcher darin besteht, daß auf Grund der Verwendung von Logic-Level Leistungs-MOSFETS die erfindungsgemäße Einrichtung auf besonders einfache Weise zusammen mit Mikrocomputern eingesetzt werden kann.

Zeichnung

Die Erfindung wird nachstehend anhand zeichnereisch dargestellter Ausführungsbeispiele näher erläutert, aus denen weitere Vorteile und Merkmale hervorgehen. Hierbei zeigt Figur 1 ein erstes Ausführungsbeispiel der erfindungsgemäßen Einrichtung, Figur 2 ein weiteres Ausführungsbeispiel mit zusätzlichen Diagnoseeinrichtungen, Figur 3 ein Ausführungsbeispiel einer mit diskreten Bauteilen aufgebauten Spannungsreglerschaltung, Figur 4 ein Ausführungsbeispiel einer Stromquelle zur Gatespannungssteuerung mit Schaltanschlüssen für eine Bremsung des elektromagnetischen Verbrauchers, und Figur 5 Diagramme von im Betrieb auftretenden Spannungen und Strömen.

Beschreibung der Ausführungsbeispiele

Bei den Ausführungsbeispielen handelt es sich um Einrichtungen zur Steuerung und Regelung des Stroms durch einen elektromagnetischen Verbraucher in Verbindung mit Brennkraftmaschinen. Der elektromagnetische Verbraucher kann beispielsweise eine Drosselklappensteuerung für ein sogenanntes "Elektronisches Gaspedal" sein.

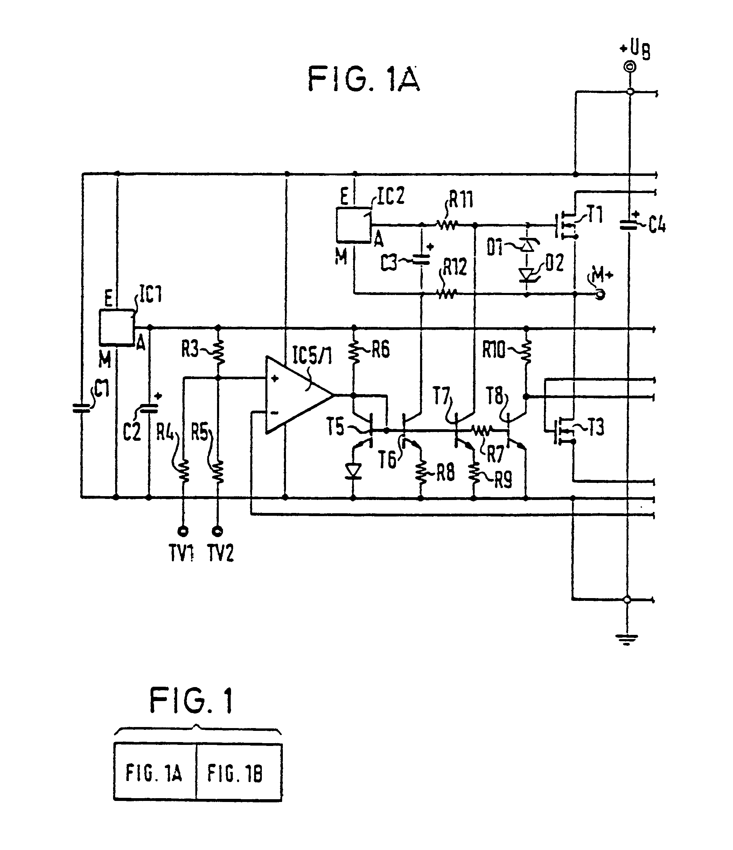

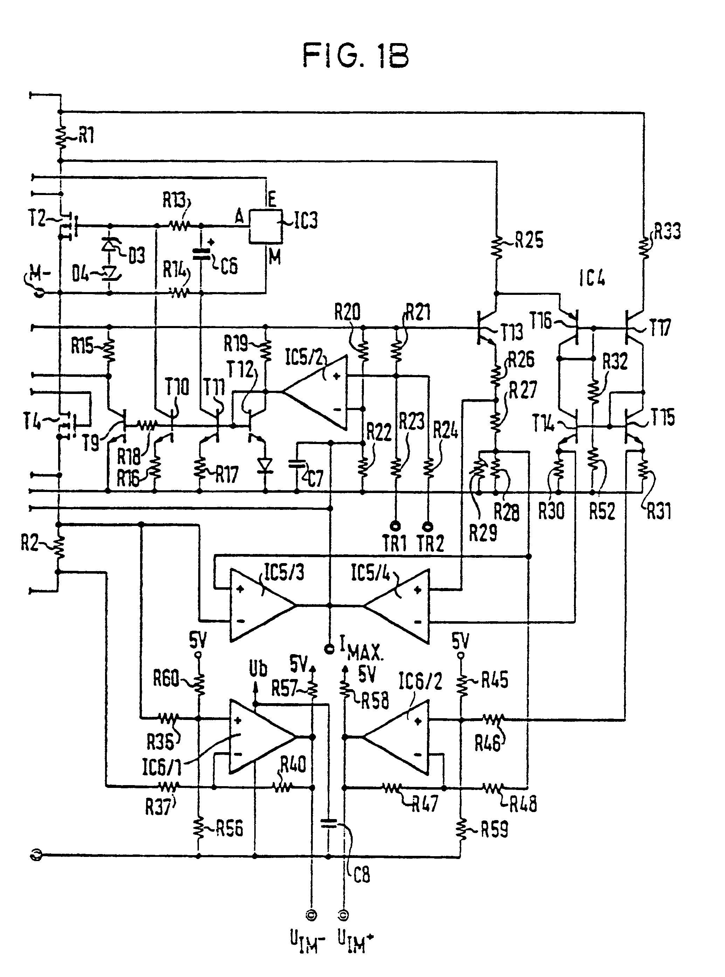

In figur 1 ist mit IC1 eine 5 Volt-Spannungsquelle bezeichnet, die auch in anderer Ausführung realisiert werden kann. Ein Eingang E der intergrierten Schaltung IC1 ist mit der Versorgungsspannung $+U_B$ verbunden, ein Eingang M über eine Sammelleitung mit Masse der Schaltung, und ein Ausgang A des IC1 ist über einen Kondensator C2 nach Masse hin überbrückt. Weiterhin ist an den Ausgang A des IC1 ein Spannungsteiler aus den Widerständen R3, R4 und R5 angeschlossen. Der jeweils andere Anschluß der Widerstände R4 und R5 führt zu herausgeführten Anschlußpunkten TV1 bzw. TV2, die in der Ausschaltphase des elektromagnetischen Verbrauchers offen liegen. Weiterhin ist der Widerstand R3 an seinem dem Ausgang A des IC1 abgewandten Ede mit dem positiven Eingang einer integrierten Schaltung IC5/1 verbunden. Ein negativer Eingang des IC5/1 ist an einen Spannungsteiler gelegt, um sicherzustellen, daß die Endstufe nur dann angesteuert werden kann, wenn sowohl TV1 (TR1) als auch TV2 (TR2) auf niedrigem Pegel liegen. IC5/1 ist ein Komparator, der die Stromquellen für die Stromsteuerorgane (Endstufentransistoren) T1 und T4 schaltet.

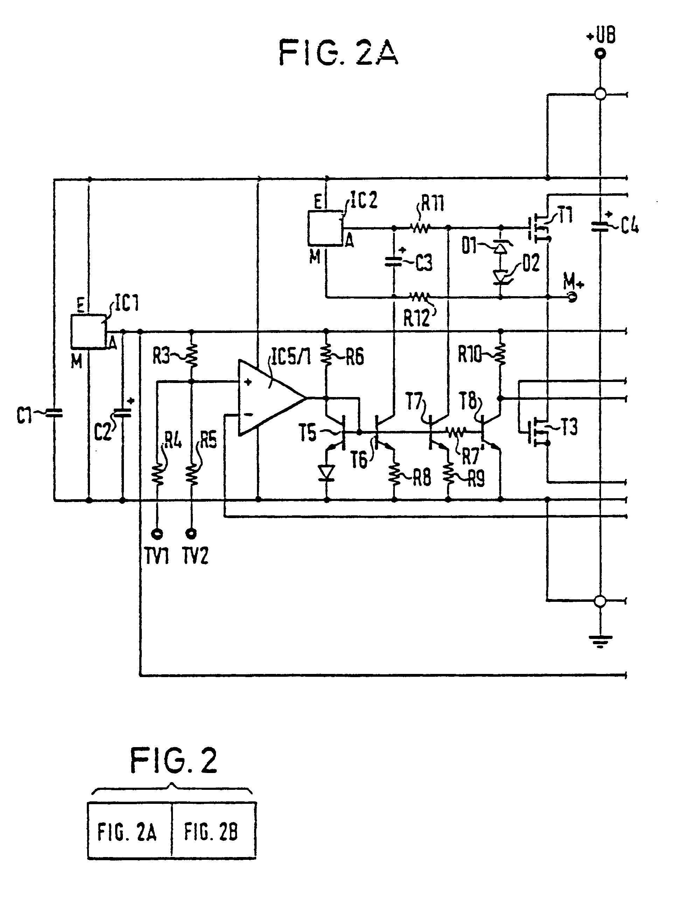

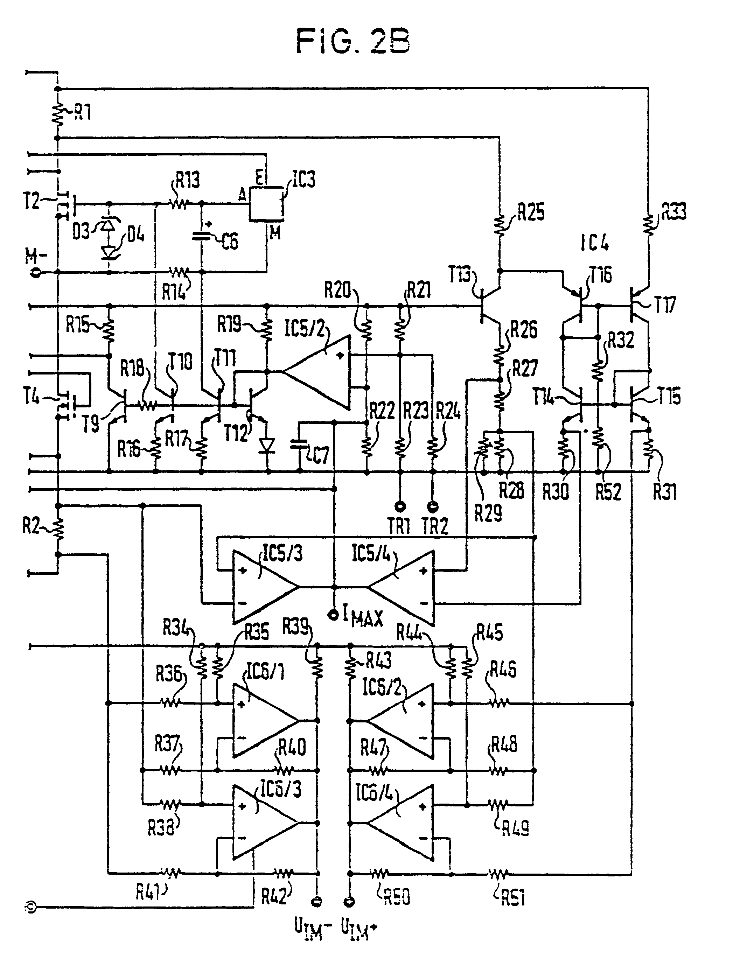

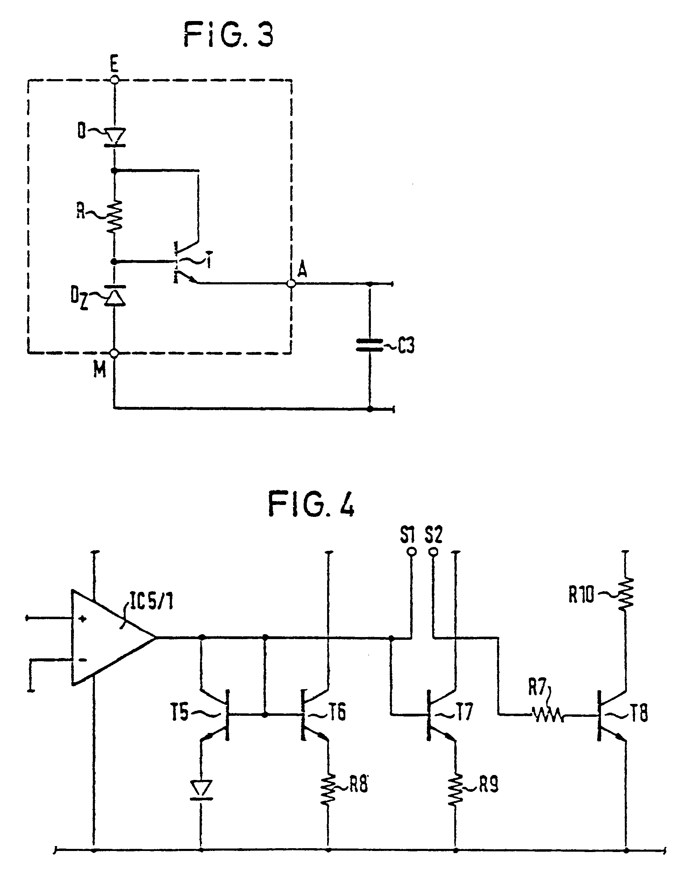

Die an den Ausgang des IC5/1 angeschlossene Stromspiegelschaltung besteht aus den Transistoren T5, T6 und T7 und liefert einen Strom von zweimel 5 mA an die Knotenpunkte der Gatespannungsversorgung des Transistors T1. In den in Figuren 1 und 2 dargestellten Ausführungsbeispielen ist der Ausgang des IC5/1 und jede Basis der Transistoren T5, T6 und T7 und über eine Widerstand R7 an die Basis eines weiteren Transistors T8 geführt. In Figur 4 wird nachstehend eine weitere Ausführungsform beschrieben, in welcher die Versorgung der Basis von T8 über Schaltkontakte S1, S2 unterbrochen und so eine Bremsung des elektromagnetischen Verbrauchers erreicht werden kann.

Die vier Endstufentransistoren T1, T2, T3 und T4 sind in einer Brückenschaltung angeordnet. Die Transistoren T1, T2, T3 und T4 sind gleich und jeweils vom Logic-Level MOSFET-Typ. Gewählt wurde ein Siemens-Leistungs-MOSFET (SIPMOS) vom Typ BUZ 71 L (L = Logic), der einen vorteilhaft niedrigen Drain-Sourcewiderstand $R_{DSon}$ von typisch 90 Milliohm aufweist. Die Verlustleistung läßt sich noch weiter senken, wenn ein SIPMOS-Typ BUZ 10 L mit einem Widerstand $R_{DSon}$ von typisch 40 Milliohm verwendet wird.

Die SIPMOS-Transistoren T1 bis T4 benötigen zur Gateansteuerung eine Spannungsüberhöhungsschaltung (Bootstrap). Hierfür ist für den SIPMOS-Transistor T1 ein Gatespannungskondensator C3 vorgesehen, der über einen Spannungsregler IC2 geladen wird. In den Figuren 1 und 2 sind diese Spannungsregler als integrierte Schaltkreise ausgeführt, Figur 3 zeigt ein Ausführungsbeispiel für einen Aufbau dieser Spannungsregler aus diskreten Bauteilen. In Figur 1 ist ein Eingang des Spannungsreglers IC2 an die Versorgungsspannung $U_B$ angeschlossen. Die Anschlüsse A und M des IC2 sind durch den Gatespannungskondensator C3 überbrückt, dessen positiver Anschluß am Anschluß A des IC2 liegt. Weiterhin ist an den Anschluß A des IC2 ein Widerstand R11 angeschlossen, dessen anderes Ende zum Gateanschluß des SIPMOS-Transistors T1 führt. Ein weiterer Widerstand R12 ist an den Anschluß M des IC2 und den negativen Anschluß des Kondensators C3 angeschlossen und an seinem anderen Ende mit dem Sourceanschluß des Transistors T1 und einer Klemme M + zum Anschluß eines elektromagnetischen Verbrauchers verbunden. Zwischen dem Gateanschluß des Transistors T1 und der Klemme M + liegen zwei gegensinnig geschaltete Zenerdioden D1 und D2. An den negativen Anschluß des Kondensators C3 ist weiterhin der Kollektor des Stromquellen-Transistors T6 angeschlossen, und der Kollektor des Stromspiegel-Transistors T7 ist mit dem Gate des SIPMOS-Transistors T1 verbunden.

In entsprechender Weise ist zur Gatespannungsversorgung des SIPMOS-Transistors T2 ein Spannungsregler IC3 mit einem Gatespannungskondensator C6 vorgesehen; die übrige Beschaltung des Transistors T2 ist in analoger Weise zu der des Transistors T1 ausgeführt. Dementsprechend ist für den SIPMOS-Transistor T2 eine von IC5/2 gesteuerte Stromquellenschaltung T12, T11 und T10 vorgesehen, wobei gesteuert von IC5/2 ein weiterer Transistor T9 den SIPMOS-Transistor T3 schaltet. Zur Ansteuerung des IC2 sind Anschlußklemmen TR1 bzw. TR2 ("rückwärts", bezogen auf die Drehrichtung eines elektromagnetischen Verbrauchers, der an die Klemmen M + und M − der Brückenschaltung angeschlossen ist) (entsprechend TV1, TV2 "vorwärts") vorgesehen.

Ein Meßwiderstand R1 ist an die Drain-Anschlüsse der Transistoren T1 und T2 und mit seinem anderen Ende an die Versorgungsspannung $U_B$ angeschlossen; ein weiterer Meßwiderstand R2 ist symmetrisch hierzu mit seinem einen Ende an die Source-Anschlüsse der SIPMOS-Transistoren T3 und T4 und mit seinem anderen Ende an Leistungs-Masse angeschlossen. Diese beiden Widerstände R1, R2 dienen in noch zu beschreibender Weise zur Erfassung der Ströme IM + beziehungsweise IM − durch einen elektromagnetischen Verbraucher, der an die Klemmen M + und M − der Brückenschaltung angeschlossen ist.

Am der Brückenschaltung zugewandten Anschluß des Meßwiderstands R1 ist über einen Widerstand R25 der Kollektor eines Transistors T13 angeschlossen, dessen Basis mit dem Anschluß A des IC1 verbunden ist. Der Emitter des Transistors T13 ist über eine Spannungsteilerschaltung R26, R27, R28 und R29 (variabel) an einen Eingang ( + ) eines Komparators IC5/4 gelegt. Die Stromquelle T13, R25 erzeugt eine positive Vorspannung für eine Stromspiegelschaltung (die nur positive Spannungsabfälle an R1 verarbeiten kann) T14, T15, T16 und T17. Diese Stromspiegelschaltung kann auch in integrierter Form als IC4 ausgeführt sein.

Mit Hilfe der Stromspiegelschaltung wird der Spannungsabfall am Meßwiderstand R1 auf Masse bezogen. Der Emitter des Stromspiegeltransistors T14 ist mit dem zweiten Eingang ( – ) des IC5/4 verbunden. Der Ausgang des Komparators IC5/4 ist mit dem Ausgang eines weiteren Komparators IC5/3 und mit einer Anschlußklemme $I_{MAX}$ verbunden. Der positive Eingang des IC5/3 ist an den Spannungsteiler R27, R28, R29 und der negative Eingang an den brückenseitigen Anschluß des Meßwiderstandes R2 angeschlossen.

Zur Überwachung der Einschaltströme sind zwei Differenzverstärker IC6/1 und IC6/2 vorgesehen. Der positive Eingang des IC6/2 ist über einen widerstand R45 an die 5 Volt-Spannungsversorgung und über einen Widerstand R46 an den Emitter des Stromspiegeltransistors T15 angeschlossen. Der negative Eingang des IC6/2 führt über einen Widerstand R48 zum Spannungsteiler R27, R28, R29. Der Differenzverstärker IC6/2 liefert daher den Einschaltstrom als invertierte Spannung, bezogen auf + 5 Volt. Hierfür ist der Ausgang des IC6/2 an eine Anschlußklemme $U_{IM}$+ angeschlossen, von der diese Spannung abgenommen werden kann. In ähnlicher Weise ist der Differenzverstärker IC6/1 an seinem positiven Eingang über einen Widerstand R60 an die 5 Volt-Spannungsversorgung und über einen Widerstand R36 an den brückenseitigen Anschluß des Meßwiderstands R2 angeschlossen, der negative Anschluß des Differenzverstärkers IC6/1 ist über einen Widerstand R37 mit dem masseseitigen Anschluß des Meßwiderstandes R2 verbunden. Der Differenzverstärker IC6/1 liefert daher einen Wert für den Einschaltstrom als invertierte Spannung, jedoch am Massepunkt gemessen. Zur Erfassung dieser Spannung ist der Ausgang von IC6/1 an eine Anschlußklemme $U_{IM}$– geführt.

Figur 2 zeigt ein weiteres Ausführungsbeispiel der erfindungsgemäßen Einrichtung, bei der zusätlich zu den in Figur 1 dargestellten (und daher nachfolgend nicht weiter besprochenen) Bauelementen zwei weitere Differenzverstärker IC6/3 und IC6/4 zur Erfassung der Freilaufströme des elektromagnetischen Verbrauchers, der an die Anschlußklemmen M + und M – der Brückenschaltung angeschlossen ist, vorgesehen sind. Hierzu ist der positive Eingang des IC6/4 über einen Widerstand R49 an den Spannungsteiler R27, R28, R29 und der negative Eingang des IC6/4 über einen Widerstand R51 mit dem Emitter des Stromspiegel-Transistors T15 verbunden. Der Ausgang des Differenzverstärkers IC6/4 ist an den Anschlußpunkt $U_{IM}$+ geführt. Auf ähnliche Weise ist der Differenzverstärker IC6/3 an seinem positiven Eingang über einen Widerstand R38 mit dem brückenseitigen Anschluß des Meßwiderstandes R2 und an seinem negativen Eingang über einen Widerstand R41 mit dem masseseitigen Anschluß des Meßwiderstandes R2 verbunden. Der Ausgang von IC6/3 führt analog zu dem Anschlußpunkt $U_{IM}$– .

Bei einer praktischen Realisierung der in den Figuren 1 und 2 dargestellten Schaltungen wurden Bauteile mit nachstehend angegebenen Daten beziehungsweise Werten verwendet :

Für die integrierten Schaltkreise : IC1 = IC2 = IC3 : 2931, IC4 : CA 3096 AE, IC5 : CA 139 und IC6: TAE 2453 (Figur 1) beziehungsweise TAE 4453 (Figur 2).

Für die Transistoren : T1 = T2 = T3 = T4 : SIPMOS BUZ 71L, T14, T15, T16, T17 : entweder (wie voranstehend angegeben integriert) CA 3096 AE oder diskret : T14 = T15 : BCV 61 (NPN-Stromspiegel) und T16 = T17 : BCV 62 (PNP-Stromspiegel).

Für die Widerstände (Werte in Ohm, beispielsweise R1 = 10 m : 10 Milli-Ohm) (in Figuren 1 und 2): R1 = 10 m, R2 = 10 m, R3 = 2,1 k, R4 = 10 k, R5 = 10 k, R6 = 780, R7 = 10 k, R8 = 100, R9 = 100, R10 = 3,1 k, R11 = 1,5 k, R12 = 1,5 k, R13 =1,5 k, R14 = 1,5 k, R15 = 3,1 k, R16 = 100, R17 = 100, R18 = 10 k, R19 = 780, R20 = 210 k, R21 = 2,1 k, R22 = 680 k, R23 = 10 k, R24 = 10 k, R25 =100, R26 = 2,83 k, R27 =100, R28 = 110, R29 = 1 k (variabel), R30 = 2,05 k, R31 = 2,05 k, R32 = 1 M, R33 = 2,15 k. Für die Widerstände (nur in Figur 1) : R36 = 1,5 k, R37 = 1,5 k, R40 = 75 k, R45 = 1 M, R46 = 1,5 k, R47 = 75 k, R48 = 1,5 k, R52 = 1 M, R56 = 75 k, R57 = 2 k, R58 = 2 k, R59 = 75 k. Für die Widerstände (nur in Figur 2) : R34 = 215 k, R35 =215 k, R36 = 4,3 k, R37 = 4,3 k, R38 = 4,3 k, R39 = 4,64 k, R40 = 215 k, R41 = 4,3 k, R42 = 215 k, R43 = 4,64 k, R44 = 215 k, R45 = 215 k, R46 = 4,3 k, R47 = 215 k, R48 = 4,3 k, R49 = 4,3 k, R50 = 215 k, R51 = 4,3 k, R52 = 1 M.

Für die Kondensatoren (Werte in Farad, beispielsweise C1 = 220 n : 220 Nano-Farad) (Figuren 1 und 2) : C1 = 220 n, C2 = 100 µ, C3 = 100 µ, C4 = 220 µ, C6 = 100 µ, C7 = 3,3 n, C8 = 100 n.

Die Versorgungsspannung $U_B$ betrug 12 Volt (zulässig 5,5 bis 38 V) und der maximale Strom 18 A.

Die Betriebsweise einer wie in Figuren 1 und 2 dargestellt aufgebauten Schaltung wird nachstehend erläutert, wobei repräsentativ der Vorwärtszweig, dessen Betätigung durch die Anschlußpunkte TV1 und TV2 eingeleitet wird, betrachtet wird ; entsprechendes gilt für den Rückwärtszweig mit Betätigung der Klemmen TR1, TR2. Wie bereits erwähnt erfolgt das Laden der beiden Gastespannungskondensatoren C3 und C6 mit Hilfe der Spannungsregler IC2 und IC3, jedoch nur während der Ausschaltzeit der SIPMOS-Endstufentransistoren T1, T2, T3 und T4.

In der Ausschaltphase sind die Eingänge TV1 beziehungsweise TV2 offen ( + 5 Volt), ICR/1 sperrt am Ausgang (open collector) und die Stromquellenschaltung T5, T6 und T7 liefert zweimal 5 mA an die Knotenpunkte der Gatespannungsversorgung des Transistors T1. Diese beiden Stromquellen sorgen erstens für eine Abschaltung des Transistors T1 und zweitens für eine sichere Aufladung des Kondensators C3 über den Spannungsregler IC2, und zwar für alle vorkommenden Potentiale ( – 0,7 Volt $\leq$ M+ $\leq U_B$ + 0,7 Volt) an der Motorklemme M + . Der SIPMOS-Transistor T4 wird über den Transistor T8 abgeschaltet.

In der Einschaltphase liegen TV1 und TV2 an Masse, IC5/1 schaltet die Stromquelle T5, T6 und T7 und ebenso den Transistor T8 ab. Das Gate des SIPMOS-Transistors T1 wird jetzt über den Gatespannungskondensator C3 und die Widerstände R11/R12 versorgt, IC5/2 ist inaktiv. Der SIPMOS-Transistor T4 wird über den Widerstand R10 angesteuert.

Der Komparator IC5/4 ist über den Transistor T13 um die Offsetspannung $U_{Offset}$ korrigiert und schaltet bei Überschreiten eines Maximalstroms $I_{MAX}$ durch und entlädt den Kondensator C7. Erst nach Unterschreitung dieses Maximalstroms beginnt der Kondensator C7 sich wieder aufzuladen. Solange die Spannung am Kondensator C7 kleiner ist als etwa 3,5 Volt, wird die Endstufe über die Komparatoren IC5/1 und IC5/2 gesperrt. Die Zeitkonstanten für die Aufbeziehungsweise Entladezeit des Kondensators C7 sind so gewählt, daß sich im Kurzschlußfall des an den Klemmen M+, M− der Brückenschaltung liegenden elektromagnetischen Verbrauchers ein Einschalttastverhältnis von 1% ergibt. Hiermit ist ein sicherer Kurzschlußschutz gewährleistet. Werden die Transistoren T1, T2, T3 und T4 in der Brückenschaltung ersetzt durch Typen mit integrierter Temperatursicherung, so ist die Schaltung auch gegen schleichende Kurzschlüsse, also Ströme knapp unterhalb der Abschaltschwelle, geschützt. Das "harte" Abschalten bei Strömen oberhalb von $I_{MAX}$ kann über die entsprechende Anschlußklemme $I_{MAX}$ abgefragt werden.

Für eine Stromregelung wird der momentane Strom IM des elektromagnetischen Verbrauchers aus der am Widerstand R30 anliegenden Spannung mit Hilfe der Differenzverstärkerschaltung erzeugt. Der Differenzverstärker IC6/2 liefert den Einschaltstrom als invertierte Spannung, bezogen auf + 5 Volt ; falls die Erfassung des Freilaufstroms erwünscht ist, muß IC6/4 hinzugefügt werden (Figur 2). Die Spannung $U_{IM}$ ergibt sich durch folgende Beziehung :

$$U_{IM} = 5 V - 0,5 V \times IM/A$$

Das gleiche Stromsignal liefert die Schaltung mit den Differenzverstärkern IC6/1 und IC6/3, jedoch als am Massepunkt gemessene Spannung.

Ist der an die Klemmen M+, M− der Brückenschaltung angeschlossene elektromagnetische Verbraucher beispielsweise ein Elektromotor, so läßt sich mit Hilfe des Signale $U_{IM}+$ und $U_{IM}−$ eine vollständige Diagnose der Brückenendstufe realisieren. Bei einem Motornebenschluß ist nämlich $U_{IM}+$ gleich $U_{IM}−$, aber erhöht während der Einschaltphase. Ein Nebenschluß nach Masse wird dadurch angezeigt, daß $U_{IM}+$ größer ist als $U_{IM}−$. Ist dagegen $U_{IM}+$ kleiner als $U_{IM}−$, so liegt ein Nebenschluß zur Versorgungsspannung $U_B$ vor.

Eine brauchbare Stromregelung und Diagnose des Betriebsablaufs ist jedoch auch ohne die Erfassung der Freilaufströme möglich, in diesem Fall können IC6/3 und IC6/4 entfallen (Figur 1).

An dem Meßwiderstand R1 erzeugt der in die Endstufe Fließende Strom einen Spannungsabfall, der über die Stromspiegelschaltung T14, T15, T16, T17 auf Masse bezogen wird. Da die Stromspiegelschaltung nur positive Spannungsabfälle am Meßwiderstand R1 verarbeiten kann, wird sie mit Hilfe der Stromquelle bestehend aus Transistor T13 und Widerstand R25 positiv vorgespannt. Auf diese Weise lassen sich auch die Freilaufphasen (negative Spannungsabfälle) einwandfrei auf Masse beziehen; insbesondere verschwinden sonst vorhandene Umschaltspitzen beim Übergang von negativem auf positiven Spannungsabfall.

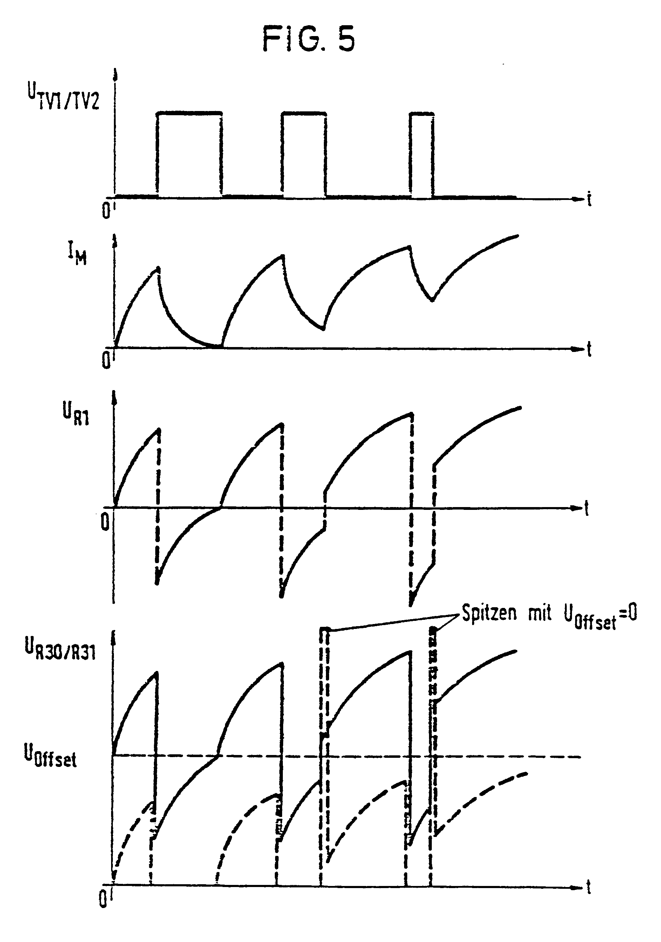

Im geschilderten Betrieb der Ausführungsformen der Erfindung anhand von Figuren 1 und 2 auftrenden typische Spannungen und Ströme sind schematisch in den Diagrammen der Figur 5 in ihrem zeitlichen Verlauf dargestellt. Das oberste Diagramm zeigt den zeitlichen Verlauf der an den Klemmen TV1 beziehungsweise TV2 anliegenden Spannung. Darunter ist der entsprechende zeitliche Verlauf des Stroms IM durch den an die Klemmen M+, M− angeschlossenen elektromagnetischen Verbraucher gezeigt. Den zeitlichen Verlauf der hierdurch an dem Meßwiderstand R1 abfallenden Spannung zeigt das nächstuntere Diagramm, und unten in Figur 5 ist der zeitliche Verlauf der an den Widerständen R30 beziehungsweise R31 abfallenden Spannung mit durchgezogenen Linien dargestellt, während zur Erläuterung die bei einer Offsetspannung $U_{Offset} = 0$ sonst auftretenden Spannungsverläufe mit den unerwünschten Spitzen gestrichelt dargestellt sind.

Figur 3 zeigt eine weitere Ausführungsform der in den Figuren 1 und 2 als integrierte Schaltungen dargestellten Spannungsregler IC2, IC3. In Figur 3 sind diese Spannungsregler diskret aufgebaut. Durch ein Rechteck mit gestrichelten Linien in Figur 3 wird hierbei der Teil des diskret aufgebauten Spannungsreglers dargestellt, der mit den Anschlüssen E, A und M statt der Spannungsregler IC2, IC3 an den entsprechenden Anschlüssen in die Ausführungsformen gemäß Figur 1 und 2 eingefügt werden kann.

Mit dem Anschlußpunkt E ist die Anode einer Diode D verbunden, deren Kathode an einen Widerstand R und an den Kollektor eines Transistors T angeschlossen ist. Der andere Anschluß des Widerstands R ist mit der Basis des Transistors T und der Kathode einer Zenerdiode $D_Z$ verbunden, deren Anodenanschluß zum Anschlußpunkt M geführt ist. Der Emitteranschluß des Transistors T ist mit dem Anschlußpunkt A verbunden. Zur Verdeutlichung ist in Figur 3 noch der Anschluß des Gatespannungskondensators C3, der zwischen die Anschlußpunkte A und M des Spannungsreglers gelegt ist, des SIPMOS-Transistors T1 von Figur 1 beziehungsweise 2 (und entsprechend natürlich der Anschluß von C6) gezeigt. Vorzugsweise wird als Diode D eine Schottky-Diode, beispielsweise vom Typ BAT 85 mit einer niedrigen Flußspannung von 0,2 bis 0,3 V verwendet, wodurch auch ein sicherer Eingangsschutz gegenüber negativen Spannungen erreicht wird. Der Transistor T kann beispielsweise vom Typ BC 639 sein und die Zenerdiode $D_Z$ eine Zenerspannung von 4,7 V aufweisen. Besonders hervorzuheben ist, daß bei der in Figur 3 dargestellten Ausführungsform mit den genannten Bauteilen die Kapazität des Gatespannungskondensators C3 (und entsprechend C6) erheblich, nämlich um einen Faktor 1000, verringert werden kann, so daß bei der in Figur 3 dargestellten Ausführungsform C3 (und entsprechend C6) nur noch eine Kapazität von 100 nF haben muß. Hierdurch läßt sich der Spannungsregler beziehungsweise die gesamte Schaltung erheblich besser integrieren oder hybridisieren.

Die in Figur 4 dargestellte Schaltung zeigt eine zusätzliche Ausführungsform mit einem Schaltanschluß für die Stromquellenschaltung T5, T6, T7 und den Schalter T8 der Figuren 1 und 2. Selbstverständlich ist auch ein Einsatz der in Figur 4 gezeigten Schaltung bei der analog aufgebauten Stromquellenschaltung T12, T11, T10 beziehungsweise dem Schalter T9 möglich. Der Ausgang des Komparators IC5/1 ist hierbei (wie in Figuren 1 und 2) jeweils an die Basis der Transistoren T5, T6, T7 geführt. Bei der in Figur 4 gezeigten Ausführungsform ist die weitere Verbindung des Ausgangs von IC5/1 zum Widerstand R7 und hierüber zum Transistor T8 jedoch unterbrochen und an Schaltanschlüsse S1, S2 herausgeführt. Ist der elektromagnetische Verbraucher ein Motor, so kann durch einen an die Anschlüsse S1, S2 angelegten Schalter die Funktion einer Motorbremse erreicht werden. Ist nämlich durch Öffnen des Schalters die Verbindung des Anschlusses S1 zum Anschluß S2 unterbrochen, so werden gleichzeitig, vergleiche Figuren 1 und 2, die Endstufentransistoren T3 und T4 leitend, wodurch der Motor überbrückt wird. Dies führt in bekannter Weise zu einer Abbremsung des Motors.

**Patentansprüche**

1. Einrichtung zur Steuerung einer aus vier Stromsteuerorganen (T1, T2, T3, T4) in Form von Feldeffekttransistoren aufgebauten, einen in einer Brückendiagonalen angeordneten Verbraucher speisenden Brückenschaltung, dadurch gekennzeichnet, daß an die Stromsteuerorgane je paarweise eine Spannungsregelschaltung zur Gatespannungsversorgung und eine Stromsteuerschaltung zur Gatespannungssteuerung angeschlossen ist, wobei die Spannungsregelschaltung eine Diode (D) aufweist, deren Kathode an den Kollektor eines NPN-Transistors (T) und an einen Widerstand (R) angeschlossen ist, dessen anderer Anschluß an die Basis des Transistors (T), mit der die Kathode einer Zenerdiode ($D_Z$) verbunden ist, angeschlossen ist.

2. Einrichtung nach Anspruch 1, dadurch gekennzeichnet, daß an einen Anschluß (A) der Spannungsregelschaltung eine Kapazität (C3, C6) zur Gate-Ansteuerung der Stromsteuerorgane (T1, T2) angeschlossen ist.

3. Einrichtung nach einem der Ansprüche 1 und 2, dadurch gekennzeichnet, daß die Aufladung der Kapazität (C3, C6) nur während der Ausschaltzeit der Stromsteuerorgane (T1, T2, T3, T4) erfolgt.

4. Einrichtung nach einem der Ansprüche 1 bis 3, dadurch gekennzeichnet, daß eine Stromüberwachungsschaltung (C7, IC5/4) vorgesehen ist, die eine Vergleicherschaltung (IC5/4) aufweist, die bei einem Maximalstrom ($I_{MAX}$) durchschaltet, eine Kapazität (C7) entlädt und die Stromsteuerorgane (T1, T2, T3, T4) über die Vergleicherschaltung (IC5/1, IC5/2) sperrt.

5. Einrichtung nach einem der Ansprüche 1 bis 4, dadurch gekennzeichnet, daß eine Korrekturschaltung (T13, R26, R27, R28, R29) zur Erzeugung einer Offsetspannung ($U_{Offset}$) vorgesehen ist, die an den Eingang der Vergleicherschaltung (IC5/4) angelegt ist.

6. Einrichtung nach einem der Ansprüche 1 bis 5, dadurch gekennzeichnet, daß eine an einen Meßwiderstand (R2) angeschlossene Diagnoseschaltung (R36, R37, IC6/1) mit einem Differenzverstärker (IC6/1) zur Erfassung des Stroms (IM) durch den Verbraucher als Spannung ($U_{IM}-$) gegen Masse vorgesehen ist.

7. Einrichtung nach einem der Ansprüche 1 bis 6, dadurch gekennzeichnet, daß eine an einen Meßwiderstand (R1) angeschlossene Diagnoseschaltung (R46, R48, IC6/2) mit einem Differenzverstärker (IC6/2) zur Erfassung des Stroms (IM) durch den Verbraucher als invertierte Spannung ($U_{IM}+$) gegen die Versorgungsspannung ($U_B$) vorgesehen ist.

8. Einrichtung nach einem der Ansprüche 1 bis 7, dadurch gekennzeichnet, daß eine weitere, an den Meßwiderstand (R1; R2) angeschlossene Diagnoseschaltung (R38, R41, IC6/3; R49, R51, IC6/4) mit einem Differenzverstärker (IC6/3; IC6/4) zur Erfassung der Freilaufströme vorgesehen ist.

9. Einrichtung nach einem der Ansprüche 1 bis 8, dadurch gekennzeichnet, daß zwischen den Meßwiderstand (R1) und die Diagnoseschaltung (R46, R48, IC6/2) und/oder die Diagnoseschaltung (R49, R51, IC6/4) die Korrekturschaltung (T13, R26, R27, R28, R29) und eine dieser nachgeschaltete Stromspiegelschaltung (T14, T15, T16, T17) geschaltet ist.

10. Einrichtung nach einem der Ansprüche 1 bis 9, dadurch gekennzeichnet, daß in der Stromquellenschaltung (T5, T6, T7, T8) ein Schaltanschluß (S1, S2) vorgesehen ist, in dessen unterbrochenem Zustand der Verbraucher überbrückt ist.

11. Einrichtung nach einem der Ansprüche 1 bis 10, dadurch gekennzeichnet, daß den nicht-invertierenden Eingängen der Differenzverstärker (IC6/1, IC6/2) eine positive Offsetspannung in Höhe der zu erwartenden Null-Offset-Spannung aufgeschaltet ist.

12. Einrichtung nach einem der Ansprüche 1 bis 11, dadurch gekennzeichnet, daß die Stromsteuerorgane (T1, T2, T3, T4) eine integrierte Temperatursicherung aufweisen.

## Claims

1. Device for controlling a bridge circuit constructed of four current control elements (T1, T2, T3, T4) in the form of field-effect transistors and feeding a load arranged in one bridge diagonal, characterised in that a voltage regulating circuit for gate voltage supply and a current control circuit for gate voltage control are in each case connected in pairs to the current control elements, the voltage regulating circuit exhibiting a diode (D), the cathode of which is connected to the collector of an NPN transistor (T) and to a resistor (R), the other connection of which is connected to the base of the transistor (T) to which the cathode of a Zener diode ($D_Z$) is connected.

2. Device according to Claim 1, characterised in that a terminal (A) of the voltage regulating circuit is connected to a capacitance (C3, C6) for driving the gate of the current control elements (T1, T2).

3. Device according to one of Claims 1 or 2, characterised in that the capacitance (C3, C6) is only charged up during the off time of the current control elements (T1, T2, T3, T4).

4. Device according to one of Claims 1 to 3, characterised in that a current monitoring circuit (C7, IC5/4) is provided which exhibits a comparator circuit (IC5/4), which switches to conduction with a maximum current ($I_{MAX}$), discharges a capacitance (C7) and cuts off the current control elements (T1, T2, T3, T4) via the comparator circuit (IC5/1, IC5/2).

5. Device according to one of Claims 1 to 4, characterised in that a correction circuit (T13, R26, R27, R28, R29) is provided for generating an offset voltage ($U_{Offset}$) which is applied to the input of the comparator circuit (IC5/4).

6. Device according to one of Claims 1 to 5, characterised in that a diagnostic circuit (R36, R37, IC6/1), connected to a sensing resistor (R2), comprising a differential amplifier (IC6/1) is provided for sensing the current (IM) through the load as a voltage ($U_{IM-}$) with respect to earth.

7. Device according to one of Claims 1 to 6, characterised in that a diagnostic circuit (R46, R48, IC6/2), connected to a sensing resistor (R1), comprising a differential amplifier (IC6/2) is provided for sensing the current (IM) through the load as an inverted voltage ($U_{IM}+$) with respect to the supply voltage ($U_B$).

8. Device according to one of Claims 1 to 7, characterised in that a further diagnostic circuit (R38, R41, IC6/3 ; R49, R51, IC6/4), connected to the sensing resistor (R1 ; R2), comprising a differential amplifier (IC6/3 ; IC6/4) is provided for sensing the freewheeling currents.

9. Device according to one of Claims 1 to 8, characterised in that the correction circuit (T13, R26, R27, R28, R29) and a current balancing circuit (T14, T15, T16, T17) following this correction circuit is connected between the sensing resistor (R1) and the diagnostic circuit (R46, R48, IC6/2) and/or the diagnostic circuit (R49, R51, IC6/4).

10. Device according to one of Claims 1 to 9, characterised in that a switching terminal (S1, S2), in the interrupted state of which the load is bypassed, is provided in the current source circuit (T5, T6, T7, T8).

11. Device according to one of Claims 1 to 10, characterised in that a positive offset voltage with the amplitude of the zero offset voltage to be expected is connected to the non-inverting inputs of the differential amplifiers (IC6/1, IC6/2).

12. Device according to one of Claims 1 to 11, characterised in that the current control elements (T1, T2, T3, T4) exhibit an integrated thermal fuse.

## Revendications

1. Dispositif pour commander un circuit en pont constitué par quatre organes de commande de courant (T1, T2, T3, T4) sous la forme de transistors à effet de champ, et qui alimentent un utilisateur disposé dans une diagonale de ce pont, dispositif caractérisé en ce qu'à chaque paire d'organes de commande du courant est raccordé un circuit de réglage de la tension pour l'alimentation en tension de la grille et un circuit de commande du courant pour la commande de la tension de grille, cependant que le circuit de réglage de la tension comporte une diode (D) dont la cathode est raccordée au collecteur d'un transistor NPN (T) et à une résistance (R), dont l'autre raccordement est relié à la base du transistor (T) à laquelle est reliée la cathode d'une diode de Zeneer ($D_Z$).

2. Dispositif selon la revendication 1, caractérisé en ce que, à un raccordement (A) du circuit de réglage de la tension, est reliée une capacité (C3, C6) pour la commande de grille des organes de commande de courant (T1, T2).

3. Dispositif selon une des revendications 1 et 2, caractérisé en ce que la charge de la capacité (C3, C6) s'effectue uniquement pendant la période de mise hors circuit des organes de commande du courant (T1, T2, T3, T4).

4. Dispositif selon une des revendications 1 à 3, caractérisé en ce qu'il est prévu un circuit de surveillance du courant (C7, IC5/4), qui comporte un circuit comparateur (IC5/4), qui établit la connexion pour un courant maximal ($I_{MAX}$), décharge une capacité (C7) et bloque les organes de commande du courant (T1, T2, T3, T4) par l'intermédiaire du circuit comparateur (IC5/1, IC5/2).

5. Dispositif selon une des revendications 1 à 4, caractérisé en ce qu'il est prévu un circuit de correction (T13, R26, R27, R28, R29) pour obtenir une tension décalée ($U_{Offset}$), qui est appliquée à l'entrée du circuit comparateur (IC5/4).

6. Dispositif selon une des revendications 1 à 5, caractérisé en ce qu'il est prévu un circuit de diagnostic (R36, R37, IC6/1) raccordé à une résistance de mesure (R2) et comportant un amplificateur différenciateur (IC6/1) pour détecter, sous la forme de tension ($U_{IM-}$) par rapport à la masse, le courant (IM) traversant l'utilisateur.

7. Dispositif selon une des revendications 1 à 6, caractérisé en ce qu'il est prévu un circuit de diagnostic (R46, R48, IC6/2) raccordé à une résistance de mesure (R1) et comportant un amplificateur différenciateur (IC6/2) pour détecter, sous la forme de tension inversée ($U_{IM+}$) par rapport à la tension d'alimentation ($U_B$), le courant (IM) traversant l'utilisateur.

8. Dispositif selon une des revendications 1 à 7, caractérisé en ce qu'il est prévu un autre circuit de diagnostic (R38, R41, IC6/3 ; R49, R51, IC6/4) raccordé à la résistance de mesure (R1 ; R2) avec un amplificateur différenciateur (IC6/3 ; IC6/4) pour détecter les courants de marche libre.

9. Dispositif selon une des revendications 1 à 8, caractérisé en ce que, entre la résistance de mesure (R1) et le circuit de diagnostic (R46, R48, IC6/2) et/ou le circuit de diagnostic (R49, R51, IC6/4) est branché le circuit de correction (T13, R26, R27, R28, R29) et un circuit à miroir de courant (T14, T15, T16, T17) branché à la suite de ce circuit de correction.

10. Dispositif selon une des revendications 1 à 9, caractérisé en ce que dans le circuit de source de courant (T5, T6, T7, T8), il est prévu un raccordement de commutation (S1, S2) dans l'état interrompu duquel l'utilisateur est shunté.

11. Dispositif selon une des revendications 1 à 10, caractérisé en ce qu'aux entrées non inversées de l'amplificateur différenciateur (IC6/1, IC6/2) est appliquée une tension positive de décalage au niveau de la tension nulle de décalage à attendre.

12. Dispositif selon une des revendications 1 à 11, caractérisé en ce que les organes de commande du courant (T1, T2, T3, T4) comportent une sécurité thermique intégrée.

# FIG. 1A

# FIG. 1

| FIG. 1A | FIG. 1B |
|---------|---------|

# FIG. 1B

# FIG. 2A

# FIG. 2

| FIG. 2A | FIG. 2B |
|---------|---------|

# FIG. 2B

# FiG. 3

# FIG. 4

# FIG. 5

$U_{TV1/TV2}$

$I_M$

$U_{R1}$

Spitzen mit $U_{Offset}=0$

$U_{R30/R31}$

$U_{Offset}$